(19) Europäisches Patentamt
European Patent Office
Office européen des brevets

(11) **EP 3 041 120 B1**

(12) **EUROPEAN PATENT SPECIFICATION**

(45) Date of publication and mention
of the grant of the patent:
**18.08.2021 Bulletin 2021/33**

(51) Int Cl.:
*H02M 1/38* (2007.01)          *H02M 7/5387* (2007.01)
*H03K 17/08* (2006.01)

(21) Application number: **15199142.9**

(22) Date of filing: **10.12.2015**

(54) **DRIVER AND THREE-PHASE BLDC MOTOR INCLUDING THE SAME**

TREIBER UND DREIPHASEN-BLDC-MOTOR DAMIT

CONDUCTEUR ET MOTEUR BLDC TRIPHASÉ COMPRENANT CELUI-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.12.2014 CN 201420869094 U**

(43) Date of publication of application:
**06.07.2016 Bulletin 2016/27**

(73) Proprietor: **Robert Bosch GmbH
70442 Stuttgart (DE)**

(72) Inventors:
• **Zhang, Lin
200335 Shanghai (CN)**
• **Schiemann, Werner
72762 Reutlingen (DE)**
• **Joos, Joachim
72762 Reutlingen (DE)**

(56) References cited:
**DE-A1- 10 343 278      JP-A- S63 265 174
US-A- 4 953 070       US-A- 5 187 387
US-A- 5 408 150**

EP 3 041 120 B1

**Description**

TECHNICAL FIELD

The present invention relates to a driver for three-phase BLDC (brushless direct-current) motor and a BLDC motor including the same to achieve shorter dead time duration and save calculation resource of micro-controller therein.

BACKGROUND

US 5408150 A discloses Circuit for driving two power mosfets in a half-bridge configuration. The driver circuit includes shoot-through reduction circuitry for monitoring the gate-to-source voltages of the two power transistors so as to inhibit the turning-ON of each power transistor until the gate-to-source voltage of the other power transistor has fallen to a voltage level indicative of the other transistor being OFF.

US 4953070 A relates to a method for transverse-current-free operation of a push-pull circuit configuration having two output transistor arrays of complementary types with output circuits interconnected in series, and a trigger circuit triggering the output transistor arrays with two push-pull signals being derived from one input signal and having mutually associated edges consecutively following one another with temporal separation, and detecting output currents of the output transistor arrays. The method includes releasing the particular triggering push-pull signal for an output transistor array without delay whenever the output current of the complementary output transistor arrays drops below a predetermined positive minimum value.

DE 103 43 278 Aldisloses a half bridge circuit with device for prevention of cross currents by blocking simultaneous conduction of both series semiconductor switches.

US 5187387 A discloses an overcurrent detecting apparatus. The apparatus comprises an output circuit and a detecting circuit which are formed on a chip. The detecting circuit comprises a current mirror build by a number of bipolar transistors.

JP S63 265174 A describes an overcurrent detecting circuit for detecting a current change regardless of manufacturing errors in resistance values. The circuit provides a correcting circuit constituted by a pair of transistors forming a current mirror circuit and a resistor in a circuit for generating an input voltage to be detected.

A conventional three-phase BLDC motor comprises a motor body including a motor case, a rotor and a three-phase stator therein; and a driver, for driving the motor, including a direct-current source and a three-phase power stage made of three half bridges, each of the three half bridges comprises one pair of a high side (HS) switch and a high side (HS) gate driver and one pair of a low side (LS) switch and a low side (LS) gate driver; and a micro-controller including a dead time control means. In general, a power MOSFET is adopted as the HS switch and the LS switch, and the power MOSFET has a turning on threshold with respect to gate-source voltage difference. In each half bridge, the drain of the power MOSFET as the HS switch is connected to a direct-current source (DC) and the source of the power MOSFET as the LS switch is connected to the ground.

To guarantee no cross current from the direct-current source to ground, HS switch and

LS switch in same half bridge are forbidden to switch on at the same time. A dead time thus is introduced to implement this non-overlap switching.

In prior art, several different schemes are implemented to prevent power MOSFETs as the HS switch and the LS switch respectively switching on at the same time, which comprises:

(1) Clock-based dead time control scheme (software type)
The micro-controller includes an internal high frequency clock for programming and setting a dead time for the power MOSFET. The scheme is easy to be implemented and has no extra requirement on hardware of the micro-controller. However, the scheme costs a lot of calculation resources of the micro-controller, resulting in one powerful and expensive micro-controller is needed. Meanwhile, software in the micro-controller would be reprogrammed for different applications. For robustness, a safety margin is needed for the dead time, which leads to lower power efficient motor driving.

(2) Logic-based dead time control scheme (hardware type)
The micro-controller includes a shoot through protection circuit for processing an original control logic signal for gate driver, then outputting a control signal to control the gate driver. The shoot through protection circuit is constructed to prevent the HS switch and the LS switch in same half bridge switching on at the same time. Once a power MOSFET as the HS switch (or the LS switch) in a half bridge is switch on, the shoot through protection circuit will ignore any turn on command for switching on the other power MOSFET in the same half bridge, until the MOSFET in switch on state is switched off The delay there between is realized by a logic delay, which is stable but not programmable (Example: International Rectifier, AUIRS2336S, datasheet page 18).

(3) Clock-based dead time control scheme (hardware type)

The driver includes an accurate high frequency oscillator for programming the dead time. In the acheme, the calculation power of the micro-controller is saved, thus a cheaper & less powerful micro-controller can be used. Further, software in the micro-controller can be programmed by communication with micro-controller. For robustness, a safety margin is also needed for the dead time, which leads to lower power efficiency of BLDC motor. Further, the step for programming the dead time is also limited by accuracy of internal oscillator frequency (Example: Free scale, MC33937, datasheet, page 36, "Dead time command").

(4) RC-based dead time control scheme (hardware type)

Instead of high accuracy oscillator, simply resistors and capacitors are adopted in the micro-controller to define the dead time. The drawback of the scheme is that step and accuracy is limited, and more safety margin for the dead time is also needed because that the parameter of resistors and capacitors would vary in different working environment and RC time constant would generate a great change (Example 1: Infineon TLE7185, datasheet, page12, "programmable internal dead time"; Example2: Texas instruments, DRV8301, datasheet, page9, "Gate timing and protection character").

SUMMARY OF THE UTILITY MODEL

According to the present invention, a driver for three-phase BLDC motor and a three-phase BLDC motor including the driver are provided to achieve shorter dead time duration and save calculation resource of micro-controller.

This is achieved by the features of the independent claims.

In an example, each of the gate-source voltage monitoring circuits comprises a resistor R1, connected to between a gate and a source of a respective power MOSFET on one side in a half bridge, for converting a voltage difference between the gate and the source of the power MOSFET into current; two pairs of current mirrors connected in series, an input of the first pair of current mirrors being connected to the resistor R1, a reference end of the first pair of current mirrors being connected to the gate of the power MOSFET, and an input of the second pair of current mirrors being connected to an output of the first pair of current mirrors , a reference end of the second pair of current mirrors being connected to the ground, for copying the current from the resistor Rlbased on each copying ratio thereof; a resistor R2, connected to an output of the second pair of current mirrors and an external stable voltage source, for converting the current back to a voltage signal representing the voltage difference; and a comparator, an input thereof being connected to between the resistor R2 and the output of the second pair of current mirrors, another input thereof being connected to a reference voltage source, and output thereof being connected to the dead time control means, for receiving the voltage signal and a reference voltage being equal to a turn-on threshold provided from the reference voltage source, comparing them with each other, and outputting a switch off signal to the dead time control means when the voltage signal is lower than the reference voltage.

In an embodiment, the driver further comprises a pre-driver, wherein the dead time control means is included in the pre-driver instead of the micro-controller, and the pre-driver is connected to each of gate-source voltage monitoring circuits and the micro-controller respectively, wherein each of gate-source voltage monitoring circuits monitors a voltage difference between gate and source node of a respective power MOSFET on one side in a half bridge, compares the voltage difference with a turn-on threshold of the respective power MOSFET and outputs a switch off signal to the dead time control means when the voltage difference is lower than the turn-on threshold, wherein after receiving the switch off signal from the gate-source voltage monitor circuit, the dead time control means generates a switch on control signal immediately to allow a power MOSFET on other side in the half bridge to switch on.

In an example, each of the drain-source voltage monitoring circuits comprises a resistor R1, connected to between drain and source node of a respective power MOSFET on one side in a half bridge, for converting a voltage difference between the drain and the source of the power MOSFET into current; two pairs of current mirrors connected in series, an input of the first pair of current mirrors being connected to the resistor R1, a reference end of the first pair of current mirrors being connected to the drain of the power MOSFET, and an input of the second pair of current mirrors being connected to an output of the first pair of current mirrors , a reference end of the second pair of current mirrors being connected to the ground, for copying the current from the resistor Rlbased on each copying ratio thereof; a resistor R2, connected to an output of the second pair of current mirrors and a external stable voltage source respectively, for converting the current back to a voltage signal representing the voltage difference; and a comparator, an input thereof being connected to between the resistor R2 and the output of the second pair of current mirrors, another input thereof being connected to a reference voltage source, and output thereof being connected to the dead time control means, for receiving the voltage signal and a predetermined voltage being larger than zero provided from the reference voltage source, comparing them with each other, and outputting a switch off signal to the dead time control means when the voltage signal is lower than the predetermined voltage.

In an embodiment, the driver further comprises a pre-driver, wherein the dead time control means is included in the pre-driver instead of the micro-controller, and the pre-driver is connected to each of drain-source voltage monitoring circuits and the micro-controller respectively, wherein each of drain-source voltage monitoring circuits monitors a voltage difference between drain and source node of a respective power MOSFET on one side in a half bridge, compares the voltage difference with a predetermined voltage being larger than zero and outputs a switch off signal to the pre-driver when the voltage difference is lower than the predetermined voltage, wherein after receiving the switch off signal from the drain-source voltage monitor circuit, the dead time control means generates a switch on control signal immediately to allow a power MOSFET on other side in the half bridge to switch on.

According to the driver and motor of present invention, timing decision regarding the switch off state of a power MOSFET is based on real operation status of the MOSFET, thus the duration of dead time is decreased and the power efficiencyof the motor is improved without risk of power stage shoot through. Further, no high requirement is made to the clock accuracy of the micro-controller in the motor so that the performance requirement to the micro-controller is reduced. A self adoptive judgement for the operation of the driver can be achieved so that no adjustment for the program in the micro-controller is need on dealing with different application or MOSFET with different characteristic, thus calculation resource of the micro-controller is saved.

BRIEF DESCRIPTION OF THE DRAWINGS

FIG. 1 is a diagram illustrating a driver for three-phase BLDC motor according to a first embodiment.

FIG. 2 is a diagram illustrating a first example of a gate-source voltage monitor.

FIG. 3 is a diagram illustrating a second example of a gate-source voltage monitor.

FIG. 4 is a diagram illustrating an embodiment of the gate-source voltage monitor.

FIG. 5 is a diagram illustrating a driver for three-phase BLDC motor.

FIG. 6 is a diagram illustrating a first example of a drain-source voltage monitor.

FIG. 7 is a diagram illustrating a second example of a drain-source voltage monitor.

FIG. 8 is a diagram illustrating an embodiment of the drain-source voltage monitor.

FIG. 9 is a diagram illustrating a driver for three-phase BLDC motor.

FIG. 10 is a diagram illustrating a driver for three-phase BLDC motor.

DESCRIPTION OF THE PREFERRED EMBODIMENTS

A description will be given for the embodiments and examples of the driver and the three-phase BLDC motor including the same in detail with reference to the drawings.

First Embodiment

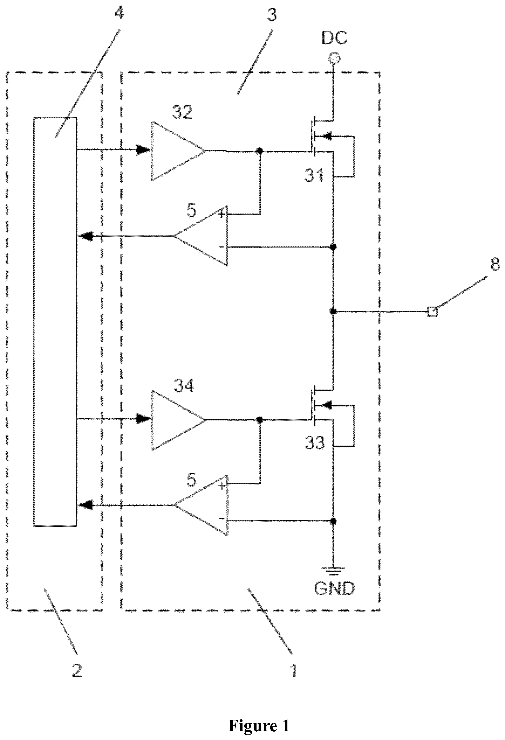

FIG. 1 is a diagram illustrating a driver 1 for three-phase BLDC motor according to a first embodiment of the present invention. The output and input of the driver 1 is connected to a stator 8 in the motor and a micro-controller 2 respectively, and the driver 1 is adopted for driving the motor according to the instruction from the micro-controller 2, wherein the driver 1 including a three-phase power stage 3 made of three half bridges (only a half bridge is shown), and the micro-controller 2 including a dead time control means 4, wherein each of the three half bridges 3 comprises one pair of a high side(HS) switch 31 and a HS gate driver 32 and one pair of a low side (LS) switch 33 and a LS gate driver 34, each of HS switch 31 and LS switch 33 adopting a power MOSFET. In each half bridge 3, the drain of the HS switch 31 is connected to a direct-current source (DC) and the source of the LS switch 33 is connected to the ground (GND).

The driver 1 further comprises gate-source voltage monitoring circuits 5, each connected to a respective power MOSFET 31 (or 33) and the dead time control means 4, for monitoring a voltage difference $V_{gs}$ between a gate and a source of a power MOSFET 31(or 33) on one side in a half bridge 3, comparing the voltage difference $V_{gs}$ with a turn-on threshold $V_{ref}$ of the power MOSFET 31 (or 33), and outputting a switch off signal to the dead time control means 4

when the voltage difference $V_{gs}$ is lower than the turn-on threshold $V_{ref}$, wherein after receiving the switch off signal from the gate-source voltage monitor circuit 5, the dead time control means 4 generating a switch on control signal immediately to allow a power MOSFET 33 (or 31) on the other side in the half bridge 3 to switch on.

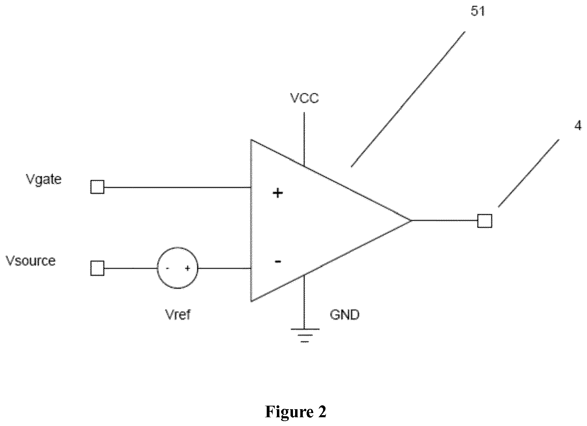

As shown in Fig. 2 illustrating a first example of the gate-source voltage monitor 5, each of the gate-source voltage monitoring circuits 5 comprises a comparator 51, an input thereof being connected to a gate of a power MOSFET 31 (or 33) on high (or low) side in a half bridge 3, another input thereof being connected in series to a reference voltage source and a source of the power MOSFET 31 (or 33), and output thereof being connected to the dead time control means 4, for comparing a voltage difference $V_{gs}$ between the gate and the source of the power MOSFET 31 (or 33) with a reference voltage $V_{ref}$ being equal to a turn-on threshold of the power MOSFET 31 (or 33) provided from the reference voltage source, and outputting a switch off signal to the dead time control means 4 when the voltage difference $V_{gs}$ is lower than the reference voltage $V_{ref}$.

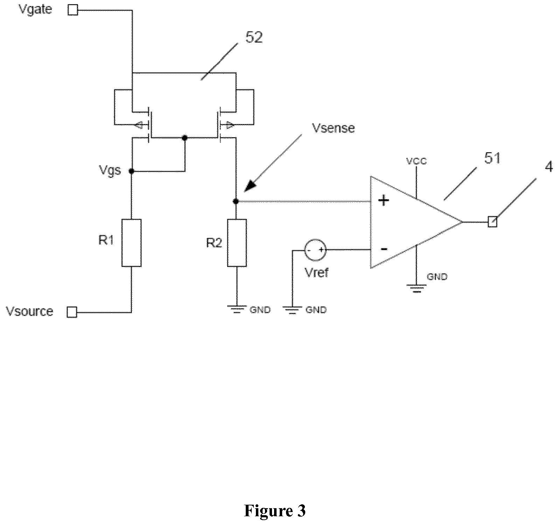

As shown in Fig. 3 illustrating a second example of the gate-source voltage monitor 5, each of the gate-source voltage monitoring circuits 5 comprises a resistor R1, connected to between a gate and a source of a power MOSFET 31 (or 33) on high (or low) side in a half bridge 3, for converting a voltage difference $V_{gs}$ between the gate and the source of the power MOSFET31 (or 33) into a current $I_{R1}$; a pair of p-channel current mirrors 52, an input thereof being connected to the resistor R1, a reference end thereof being connected to the gate of the power MOSFET 31 (or 33), for copying the current $I_{R1}$ from the resistor R1 into a current $I_{R2}$ according to a copying ratio of 1:N in the pair of p-channel current mirrors 52, that is, $I_{R1} \cdot N = I_{R2}$ ; and a resistor R2, connected to an output of the pair of p-channel current mirrors 52 and the ground (GND) respectively, for converting the current $I_{R2}$ back to a voltage signal $V_{sense}$ representing the voltage difference $V_{gs}$; and a comparator 51, an input thereof being connected to between the resistor R2 and the output of pair of p-channel current mirrors 52, another input thereof being connected to a reference voltage source, and an output thereof being connected to the dead time control means 4, for receiving the voltage signal $V_{sense}$ and a reference voltage $V_{ref}$ being equal to the turn-on threshold provided from the reference voltage source, comparing them with each other, and outputting a switch off signal to the dead time control means 4 when the voltage signal $V_{sense}$ is lower than the reference voltage $V_{ref}$.

The working principle of each gate-source voltage monitoring circuits 5 in the second example is described based on the following Equation (1):

$$\because I_{R1} \cdot N = I_{R2}$$

$$\therefore \frac{V_{gate} - V_{source} - V_{gs\_Pch\_mirror}}{R_1} \cdot N = \frac{V_{sense}}{R_2}$$

$$V_{sense} = \frac{N \cdot R_2}{R_1} \cdot (V_{gate} - V_{source} - V_{gs\_Pch\_mirror}) \tag{1}$$

wherein $I_{R1}$ represenrts a current on the resistor R1; $I_{R2}$ represenrts a current on the resistor R2; $V_{gate}$ represenrts a gate voltage of the power MOSFET 31 (or 33); $V_{source}$ represenrts a source voltage of the power MOSFET 31 (or 33); $V_{gs\_pch\_mirror}$ represenrts a voltage crossing the pair of p-channel current mirrors 52; N is a copying ratio of the pair of p-channel current mirrors 52; $V_{sense}$ represenrts a voltage crossing the resistor R2.

A current flowing will be generated when the voltage difference $V_{gs}$ between the gate and the source of the power MOSFET31 (or 33) on high (or low) side in a half bridge 3 is above the turn-on threshold ($V_{ref}$) of the power MOSFET 31(or 33). The voltage difference $V_{gs}$ ($=V_{gate}-V_{source}-V_{gs\_pch\_minor}$) will be linearly converted into a current $I_{R1}$ by the resistor R1. Then the current $I_{R1}$ is copied by the p-channel current mirror 52 based on a ration of 1: N to be a current $I_{R2}$ ($=N \cdot I_{R1}$) on the resistor R2. By the resistor R2, the current $I_{R2}$ is converted to a voltage signal $V_{sense}$ ($=R_2 \cdot I_{R2}$) representing the voltage difference $V_{gs}$. The comparator 51 receives the voltage signal $V_{sense}$ and a reference voltage $V_{ref}$ being equal to the turn-on threshold provided from the reference voltage source, compares them with each other, and outputs a switch off signal to the dead time control means 4 when the voltage signal $V_{sense}$ is lower than the reference voltage $V_{ref}$.

In the second example, a pair of p-channel current mirrors 52 is adopted such that the requirement reduction to the performance of the comparator 51 can be achieved as compared with the first example.

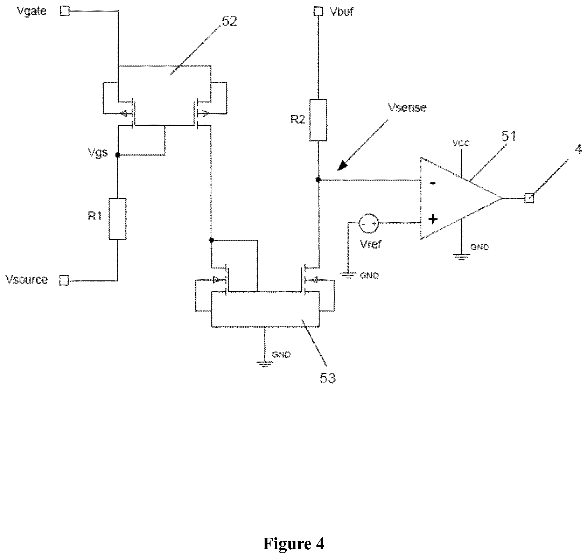

As shown in Fig. 4 illustrating a third example of the gate-source voltage monitor 5, according to the first embodiment of the present invention, each of the gate-source voltage monitoring circuits 5 comprises a resistor R1, connected to between a gate and a source of a power MOSFET 31 (or 33) on high (or low) side in a half bridge 3, for converting a voltage difference $V_{gs}$ between the gate and the source of the power MOSFET 31 (or 33) into current $I_{R1}$; two pairs of current mirrors 52 and 53 connected in series, an input of the first pair of p-channel current mirrors 52 being connected to the resistor R1, a reference end of the first pair of p-channel current mirrors 52 being connected to the gate of the power MOSFET 31 (or 33), and an input of the second pair of n-channel current mirrors 53 being connected to an output of the first pair of p-channel current mirrors 52, and a out put of the second pair of n-channel current mirrors 53 being connected to the ground (GND), for copying the current $I_{R1}$ from the resistor R1 into a current $I_{R2}$ according to a first copying ratio of 1:N in the first pair of p-channel current mirrors 52 and a second copying ration of 1:M in the second pair of n-channel current mirrors 53, that is, $I_{R1} \cdot N \cdot M = I_{R2}$ ; a resistor R2, connected to an output of the second pair of current mirrors 53 and a external stable voltage source $V_{buf}$ (e.g. 2.5V) respectively, for converting the current $I_{R2}$ back to a voltage signal $V_{sense}$ representing the voltage difference $V_{gs}$; and a comparator 51, an input thereof being connected to between the resistor R1 and the second pair of current mirrors 53, another input thereof being connected to a reference voltage source, and output thereof being connected to the dead time control means 4, for receiving the voltage signal $V_{sense}$ and a reference voltage $V_{ref}$ being equal to the turn-on threshold provided from the reference voltage source, comparing them with each other, and outputting a switch off signal to the dead time control means 4 when the voltage signal $V_{sense}$ is lower than the reference voltage $V_{ref}$.

The working principle of each gate-source voltage monitoring circuits 5 in the third example is described based on the following Equation (2):

$$\because I_{R1} \cdot N \cdot M = I_{R2}$$

$$\therefore \frac{V_{gate} - V_{source} - V_{gs\_Pch\_mirror}}{R_1} \cdot N \cdot M = \frac{V_{buf} - V_{sense}}{R_2}$$

$$V_{sense} = V_{buf} - \frac{R_2 \cdot N \cdot M}{R_1} \cdot (V_{gate} - V_{source} - V_{gs\_Pch\_mirror})$$

$$(2)$$

wherein $I_{R1}$ represenrts a current on the resistor R1; $I_{R2}$ represenrts a current on the resistor R2; $V_{gate}$ represenrts a gate voltage of the power MOSFET 31 (or 33); $V_{source}$ represenrts a source voltage of the power MOSFET 31 (or 33); $V_{gs\_pch\_mirror}$ represenrts a voltage crossing the pair of P-channel current mirrors 52; N is a copying ratio of the first pair of p-channel current mirrors 52; M is a copying ratio of the second pair of p-channel current mirrors 53; $V_{buf}$ represenrts a voltage from the external stable voltage source connected to the resistor R2; $V_{sense}$ represenrts a voltage crossing the resistor R2.

A current flowing will be generated when the voltage difference $V_{gs}$ between the gate and the source of the power MOSFET31 (or 33) on high (or low) side in a half bridge 3 is above the turn-on threshold ($V_{ref}$) of the power MOSFET 31 (or 33). The voltage difference $V_{gs}$ (=$V_{gate}$-$V_{source}$-$V_{gs\_pch\_mirror}$) will be linearly converted into a current $I_{R1}$ by the resistor R1. Then the current $I_{R1}$ is copied by the first pair of p-channel current mirror 52 (based on a ration of 1: N) and the second pair of the n-channel current mirror 53 (based on a ration of 1: M) to be a current $I_{R2}$ (=$N \cdot M \cdot I_{R1}$) on the resistor R2. By the resistor R2, the current $I_{R2}$ is converted back to a voltage signal $V_{sense}$ (=$V_{buf}$-$R_2 \cdot I_{R2}$) representing the voltage difference $V_{gs}$. The comparator 51 receives the voltage signal $V_{sense}$ and a reference voltage $V_{ref}$ being equal to the turn-on threshold provided from the reference voltage source, compares them with each other, and outputs a switch off signal to the dead time control means 4 when the voltage signal $V_{sense}$ is lower than the reference voltage $V_{ref}$.

In the third example, the voltage $V_{sense}$ is related to the external stable voltage $V_{buf}$, which can minimize comparison error from between the two pair of current mirrors 52 and 53 and comparator 51. Further, two pairs of current mirrors 52 and 53 are adopted so as to achieve more flexible of current amplification design.

## Second Embodiment

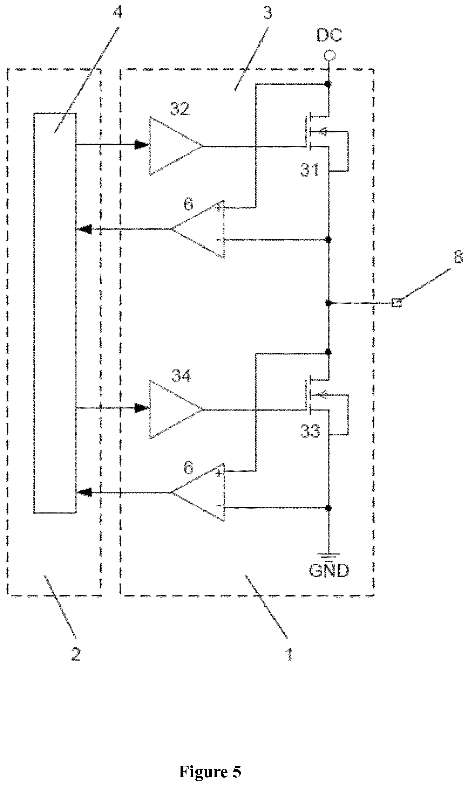

FIG. 5 is a diagram illustrating a driver 1 for three-phase BLDC motor according to a second embodiment of the present invention. The output and input of driver 1 are connected to a stator 8 in the motor and a micro-controller 2 respectively, and the driver 1 is adopted for driving the motor according to the instruction from the micro-controller 2, wherein the driver 1 including a three-phase power stage 3 made of three half bridges (only a half bridge is shown), and the micro-controller 2 including a dead time control means 4, wherein each of the three half bridges 3 comprises one pair of a high side (HS) switch 31 and a high side (HS) gate driver 32 and one pair of a low side (LS) switch 33 and a low side (LS) gate driver 34, each of HS switch 31 and LS switch 33 adopting a power MOSFET. In each half bridge, the drain of the HS switch 31 is connected to a direct-current source (DC) and the source of the LS switch 33 is connected to the ground (GND).

The driver 1 further comprises drain-source voltage monitoring circuits 6, each connected to a respective power MOSFET 31 (or 33) and the dead time control means 4, for monitoring a voltage difference $V_{ds}$ between a drain and a source of the power MOSFET 31 (or 33) on a high (or low) side in a half bridge 3, and outputting a switch off signal to the dead time control means 4 when the voltage difference $V_{ds}$ is bigger than a predetermined voltage $V_{pre}$ being larger than zero (for example, 500 mv or 1000 mv or more), wherein after receiving the switch off signal from the drain-source voltage monitor circuit 6, the dead time control means 4 generating a switch on control signal immediately to allow a power MOSFET 33 (or 31) on the other side in the half bridge 3 to switch on.

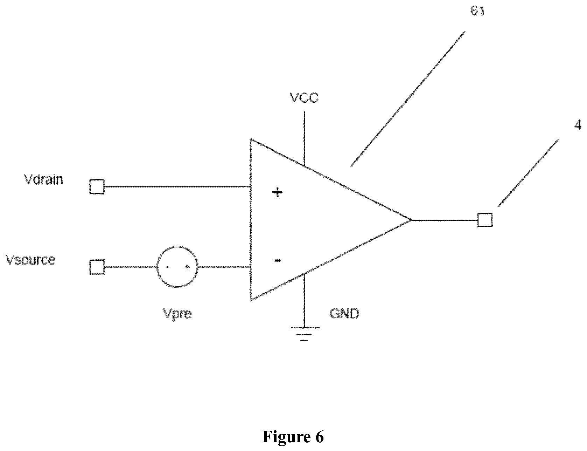

As shown in FIG. 6 illustrating a first example of the drain-source voltage monitor 6, each of the drain-source voltage monitoring circuits 6 comprises a comparator 61, an input thereof being connected to a drain of a power MOSFET 31 (or 33) on high (or low) side in a half bridge 3, another input thereof being connected in series to a reference voltage source and a source of the power MOSFET 31 (or 33), and an output thereof being connected to the dead time control means 4, for comparing a voltage difference $V_{ds}$ between the drain voltage $V_{drain}$ and the source voltage $V_{source}$ of the power MOSFET 31 (or 33) with a predetermined voltage $V_{pre}$ provided from the reference voltage source, and outputting a switch off signal to the dead time control means 4 when the voltage difference $V_{ds}$ is bigger than the predetermined voltage $V_{pre}$.

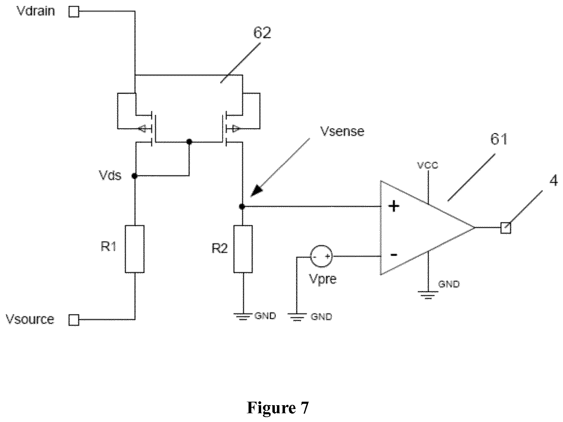

As shown in FIG. 7 illustrating a second example of the drain-source voltage monitoring circuits 6, each of the drain-source voltage monitoring circuits 6 comprises a resistor R1, connected to between a drain and a source of a power MOSFET 31 (or 33) on high (or low) side in a half bridge 3, for converting a voltage difference $V_{ds}$ between the drain and the source into a current $I_{R1}$; a pair of p-channel current mirrors 62, an input thereof being connected to the resistor R1, and a reference end thereof being connected to the drain of the power MOSFET 31 (or 33), for copying the current $I_{R1}$ from the resistor R1 into a current $I_{R2}$ according to a copying ratio of 1:N thereof, that is, $I_{R1} \cdot N = I_{R2}$; and a resistor R2, both ends thereof being connected to an output of the pair of current mirrors 62 and the ground (GND) respectively, for converting the current $I_{R2}$ back to a voltage signal $V_{sense}$ representing the voltage difference $V_{ds}$; and a comparator 61, an input thereof being connected to between the resistor R2 and the output of the pair of p-channel current mirrors 62, another input thereof being connected to a reference voltage source, and an output thereof being connected to the dead time control means 4, for receiving the voltage signal $V_{sense}$ and a predetermined voltage $V_{pre}$ being larger than zero (for example, 500 mv or 1000 mv or more) provided from the reference voltage source, comparing them with each other, and outputting a switch off signal to the dead time control means 4 when the voltage signal $V_{sense}$ is lower than the predetermined voltage $V_{pre}$.

The working principle of each drain-source voltage monitoring circuits 6 in the second example is described based on the following Equation (3):

$$\because I_{R1} \cdot N = I_{R2}$$

$$\therefore \frac{V_{drain} - V_{source} - V_{ds\_Pch\_mirror}}{R_1} \cdot N = \frac{V_{sense}}{R_2}$$

$$V_{sense} = \frac{N \cdot R_2}{R_1} \cdot (V_{drain} - V_{source} - V_{ds\_Pch\_mirror}) \tag{3}$$

wherein $I_{R1}$ represenrts a current on the resistor R1; $I_{R2}$ represenrts a current on the resistor R2; $V_{drain}$ represenrts a drain voltage of the power MOSFET 31 (or 33); $V_{source}$ represenrts a source voltage of the power MOSFET 31 (or 33); $V_{ds\_pch\_mirror}$ represenrts a voltage crossing the pair of p-channel current mirrors 62; N is a copying ratio of the pair of p-channel current mirrors 62; $V_{sense}$ represenrts a voltage crossing the resistor R2.

A current flowing will be generated when the voltage difference $V_{ds}$ is above the turn-on threshold ($V_{ref}$) of the power MOSFET 31(or 33). The voltage difference $V_{ds}$ (=$V_{drain}$-$V_{source}$-$V_{ds\_pch\_mirror}$) will be linearly converted into a current $I_{R1}$ by the resistor R1. Then the current $I_{R1}$ is copied by the p-channel current mirror 62 based on a ration of 1:N to be a current $I_{R2}$ (=$N \cdot I_{R1}$) on the resistor R2. By the resistor R2, the current $I_{R2}$ is converted to a voltage signal $V_{sense}$ (=$R_2 \cdot I_{R2}$) representing the voltage difference $V_{gs}$. The comparator 61 receives the voltage signal $V_{sense}$ and the predetermined voltage $V_{pre}$ being larger than zero (for example, 500 mv or 1000 mv or more) provided from the reference voltage source, compares them with each other, and outputs a switch off signal to the dead time control means 4 when the voltage signal $V_{sense}$ is lower than the predetermined voltage $V_{pre}$.

In the second example, a pair of current mirrors 62 is adopted such that the requirement reduction to the performance of the comparator 61 can be achieved as compared with the first example.

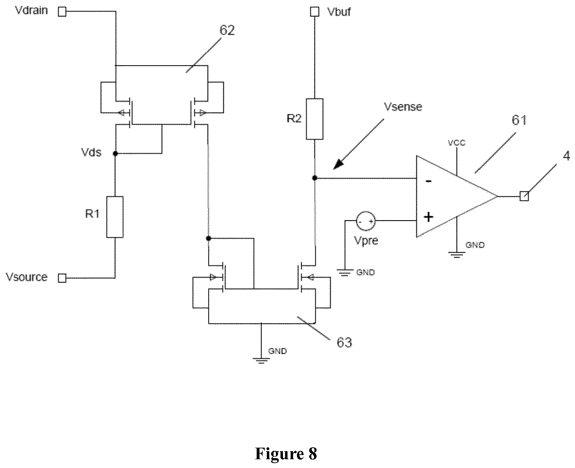

As shown in FIG. 8 illustrating a third example of the drain-source voltage monitoring circuits 6 according to the second embodiment of the present invention, each of the drain-source voltage monitoring circuits 6 comprises a resistor R1, connected to between a drain and a source of a power MOSFET 31 (or 33) on high (or low) side in a half bridge, for converting a voltage difference $V_{ds}$ between the drain and the source of the power MOSFET31 (or 33) into a current $I_{R1}$; two pairs of current mirrors 62 and 63connected in series, , an input of the first pair of p-channel current mirrors 62 being onnected to the resistor R1, a reference end of the first pair of p-channel current mirrors 62 being connected to the drain of the power MOSFET 31(or 33), and an input of the second pair of n-channel current mirrors 63 being connected to an output of the first pair of p-channel current mirrors 62, and a reference end of the second pair of n-channel current mirrors 63 being connected to the ground (GND), for copying the current $I_{R1}$ from the resistor R1 into a current $I_{R2}$ according to a first copying ratio of 1:N in the first pair of p-channel current mirrors 62 and a second copying ratio of 1:M in the second pair of n-channel current mirrors 63, that is, $I_{R1} \cdot N \cdot M = I_{R2}$ ; a resistor R2, both ends thereof being connected to an output of the second pair of current mirrors 63 and a external stable voltage source $V_{buf}$ (e.g. 2.5V) respectively, for converting the current $I_{R2}$ back to a voltage signal $V_{sense}$ representing the voltage difference $V_{ds}$; and a comparator 61, an input thereof being connected to between the resistor R1 and the output of the second pair of current mirrors 63, another input thereof being connected to a reference voltage source, and output thereof being connected to the dead time control means 4, for receiving the voltage signal $V_{sense}$ and a predetermined voltage $V_{pre}$ being larger than zero (for example, 500 mv or 1000 mv or more) provided from the reference voltage source, comparing them with each other, and outputting a switch off signal to the dead time control means 4 when the voltage signal $V_{sense}$ is lower than the predetermined voltage $V_{pre}$.

The working principle of each drain-source voltage monitoring circuits 6 in the third example is described based on the following Equation (4):

$$\because I_{R1} \cdot N \cdot M = I_{R2}$$

$$\therefore \frac{V_{drain} - V_{source} - V_{ds\_Pch\_mirror}}{R_1} \cdot N \cdot M = \frac{V_{buf} - V_{sense}}{R_2}$$

$$V_{sense} = V_{buf} - \frac{R_2 \cdot N \cdot M}{R_1} \cdot (V_{drain} - V_{source} - V_{ds\_Pch\_mirror})$$

$$(4)$$

wherein $I_{R1}$ represenrts a current on the resistor R1; $I_{R2}$ represenrts a current on the resistor R2; $V_{drain}$ represenrts a drain voltage of the power MOSFET 31 (or 33); $V_{source}$ represenrts a source voltage of the power MOSFET 31(or 33); $V_{ds\_pch\_mirror}$ represenrts a voltage crossing the pair of P-channel current mirrors 62; N is a copying ratio of the first pair of p-channel current mirrors 62; M is a copying ratio of the second pair of p-channel current mirrors 63; $V_{buf}$ represenrts a voltage from the external stable voltage source; $V_{sense}$ represents a voltage crossing the resistor R2.

A current flowing will be generated when the voltage difference $V_{ds}$ is above the turn-on threshold ($V_{ref}$) of the power MOSFET 31(or 33). The voltage difference $V_{ds}$ (=$V_{drain}$-$V_{source}$-$V_{ds\_pch\_mirror}$) will be converted into a current $I_{R1}$ by the resistor R1 linearly. Then the current $I_{R1}$ is copied by the first pair of p-channel current mirror 62 based on a ration of 1: N and the second pair of n-channel current mirror 63 based on a ration of 1: M to be a current $I_{R2}$ (=$N \cdot M \cdot I_{R1}$) on the resistor R2. By the resistor R2, the current $I_{R2}$ is converted to a voltage signal $V_{sense}$ (=$V_{buf}$-$R_2 \cdot I_{R2}$) representing the voltage difference $V_{ds}$. The comparator 61 receives the voltage signal $V_{sense}$ and the predetermined voltage $V_{pre}$ provided from the reference voltage source, compares them with each other, and outputs a switch off signal to the dead time control means 4 when the voltage signal $V_{sense}$ is lower than the predetermined voltage $V_{pre}$.

In the third example, the voltage signal $V_{sense}$ is related to the voltage $V_{buf}$ from the external stable voltage source, which can minimize the comparison error from between the two pair of current mirrors 62 and 63 and comparator 61. Further, two pairs of current mirrors 62 and 63 are adopted so as to achieve more flexible of current amplification design.

### Third Embodiment

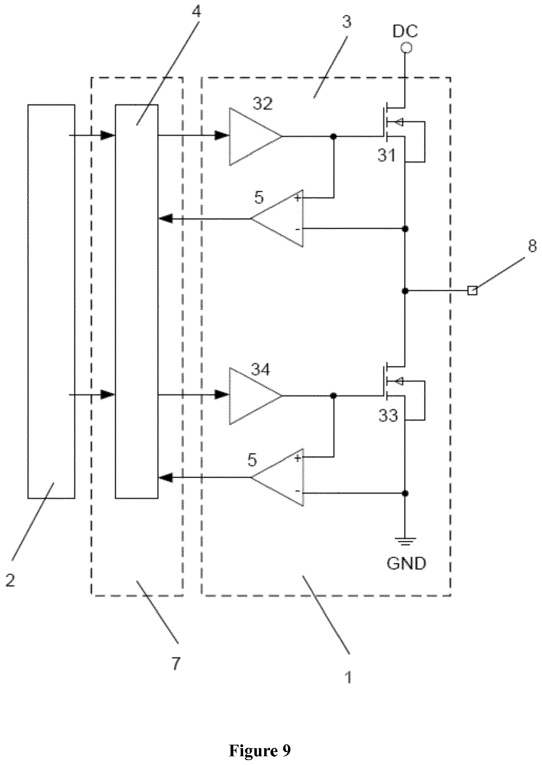

FIG. 9 is a diagram illustrating a driver 1 for three-phase BLDC motor according to a third embodiment of the present invention. The driver 1 illustrated in FIG. 9 is different from driver 1 illustrated in FIG. 1 in that the driver 1 illustrated in FIG. 9 further comprises a pre-driver 7, wherein the dead time control means 4 is included in the pre-driver

7 instead of the micro-controller 2, the pre-driver 7 is connected to each of gate-source voltage monitoring circuits 5, each of the three half bridges 3 in the three-phase power stage and the micro-controller 2 respectively. The other constitution illustrated in FIG. 9 is the same as that illustrated in FIG. 1. The same components are given the same reference numerals, and the description thereof is omitted.

In the third embodiment, each of gate-source voltage monitoring circuits 5 monitors a voltage difference $V_{gs}$ between a gate and a source of a power MOSFET 31 (or 33) on high (or low) side in a half bridge 3, compares the voltage difference $V_{gs}$ with a turn-on threshold $V_{ref}$ of the power MOSFET 31(or 33) and outputs a switch off signal to the dead time control means 4 when the voltage difference $V_{gs}$ is lower than the turn-on threshold $V_{ref}$, wherein after receiving the switch off signal from the gate-source voltage monitor circuit 5, the dead time control means 4 generates a switch on control signal immediately to allow a power MOSFET 33(or 31) on low(or high) side in the half bridge 3 to switch on.

**Fourth Embodiment**

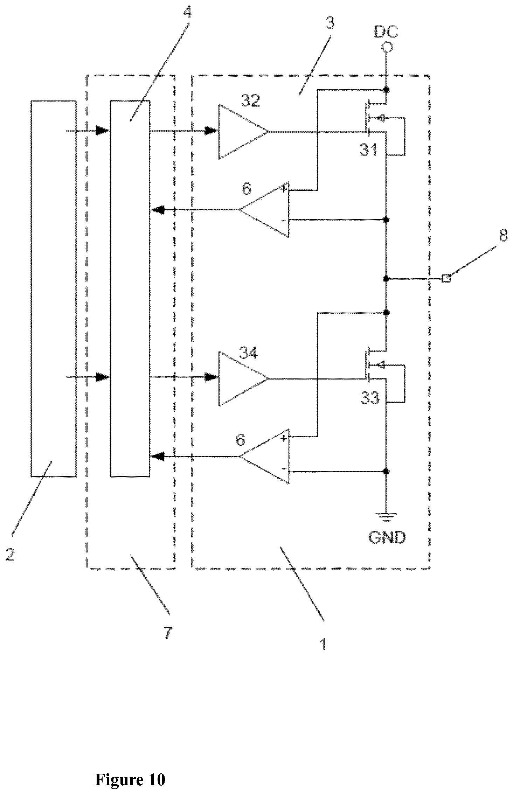

FIG. 10 is a diagram illustrating a driver 1 for three-phase BLDC motor according to a fourth embodiment of the present invention, The driver 1 illustrated in FIG. 10 is different from driver 1 illustrated in FIG. 5 in that the driver 1 illustrated in FIG. 10 further comprises a pre-driver 7, wherein the dead time control means 4 is included in the pre-driver 7 instead of the micro-controller 2, and the pre-driver 7 is connected to each of drain-source voltage monitoring circuits 6, each of the three half bridges 3 (only one half bridge is shown) in the three-phase power stage and the micro-controller 2 respectively. The other constitution illustrated in FIG. 10 is the same as that illustrated in FIG. 5. The same components are given the same reference numerals, and the description thereof is omitted.

In the fourth embodiment, each of drain-source voltage monitoring circuits 6 monitors a voltage difference $V_{ds}$ between a drain and a source of a power MOSFET 31 (or 33) on high (or low) side in a half bridge 3, compares the voltage difference $V_{ds}$ with a predetermined voltage $V_{pre}$ being larger than zero (for example, 500 mv or 1000 mv or more) and outputs a switch off signal to the dead time control means 4 when the voltage difference $V_{ds}$ is bigger than the predetermined voltage $V_{pre}$, wherein after receiving the switch off signal from the drain-source voltage monitor circuit 6, the dead time control means 4 generates a switch on control signal immediately to allow a power MOSFET 33(or 31) on low (or high) side in the half bridge 3 to switch on.

Although present invention has been described by reference to certain embodiments, but is not limited to the embodiments described above. Modifications and variations of the embodiments will occur to those skilled in the art, in light of above teachings. The scope of present invention is defined with reference to the claims enclosed.

**Claims**

1. A driver (1) for three-phase brushless direct-current, BLDC, motor,
   wherein output and input of the driver are connectable to a stator (8) in the motor and a micro-controller (2) respectively, and the driver (1) is adapted for driving the motor according to the instruction from the micro-controller (2),
   wherein the driver (1) includes a three-phase power stage made of three half bridges, and the micro-controller (2) includes a dead time control means (4),
   wherein each of the three half bridges comprises one pair of a high side, HS, switch (31) and a HS gate driver (32) and one pair of a low side, LS, switch (33) and a LS gate driver (34), each of HS switch (31) and LS switch (33) adopting a power MOSFET, wherein
   the driver (1) further comprises gate-source voltage monitoring circuits (5), each connected to a respective power MOSFET and the dead time control means (4), the gate-source voltage monitoring circuits (5) are configured to monitor a voltage difference between a gate electrode and a source electrode of a power MOSFET on one side in a half bridge, compare the voltage difference with a turn-on threshold of the power MOSFET, and output a switch off signal to the dead time control means (4) when the voltage difference is lower than the turn-on threshold of the power MOSFET,
   wherein after receiving the switch off signal from the gate-source voltage monitor circuit (5), the dead time control means (4) is configured to generate a switch on control signal immediately to allow a power MOSFET on other side in the half bridge to switch on;
   **characterized in that** each of the gate-source voltage monitoring circuits (5) comprises a first resistor (R1) configured to convert a voltage difference between the gate and the source of a respective power MOSFET on one side in a half bridge into current;
   a pair of p-channel current mirrors (52), an input thereof being connected to the first resistor (R1), a reference end thereof being connected to the gate of the power MOSFET, for copying the current from the first resistor (R1) based on a first copying ratio, the first resistor being connected between the input of the pair of p-channel current mirrors and the source of the power MOSFET;

a pair of n-channel current mirrors (53), an input of the pair of n-channel current mirrors (53) being connected to an output of the pair of p-channel current mirrors (52), and an output of the pair of n-channel current mirrors (53) being connected to the ground (GND), for copying a first current from the first resistor (R1) into a second current according to the first copying ratio of in the first pair of p-channel current mirrors (52) and a second copying ratio in the pair of n-channel current mirrors (53);

a second resistor (R2), connected to an output of the pair of n-channel current mirrors (53) and an external stable voltage source (Vbuf) respectively, for converting the second current back to a voltage signal (Vsense) representing the voltage difference; and

a comparator (51), an input thereof being connected to between the first resistor (R1) and the pair of n-channel current mirrors (53), another input thereof being connected to a reference voltage source(Vref), and output thereof being connected to the dead time control means (4), for receiving the voltage signal (Vsense) and a reference voltage (Vref) being equal to the turn-on threshold provided from the reference voltage source, comparing them with each other, and outputting a switch off signal to the dead time control means (4) when the voltage signal (Vsense) is lower than the reference voltage (Vref).

2. The driver (1) according to claim 1, further comprising a pre-driver, wherein the dead time control means is included in the pre-driver (7) instead of the micro-controller (2), and the pre-driver (7) is connected to each of gate-source voltage monitoring circuits (5) and the micro-controller (2) respectively, wherein each of gate-source voltage monitoring circuits (5) monitors a voltage difference between gate and source node of a respective power MOSFET on one side in a half bridge, compares the voltage difference with a turn-on threshold of the respective power MOSFET and outputs a switch off signal to the dead time control means (4) when the voltage difference is lower than the turn-on threshold, wherein after receiving the switch off signal from the gate-source voltage monitor circuit (5), the dead time control means (4) generates a switch on control signal immediately to allow a power MOSFET on other side in the half bridge to switch on.

3. A driver (1) for three-phase brushless direct-current, BLDC, motor,

wherein output and input of the driver (1) are connectable to a stator in the motor and a micro-controller (2) respectively, and

the driver (1) is adapted for driving the motor according to the instruction from the micro-controller (2), wherein the driver (1) includes a three-phase power stage made of three half bridges, and the micro-controller (2) includes a dead time control means (4),

wherein each of the three half bridges comprises one pair of a high side, HS,) switch (31) and a HS gate driver (32) and one pair of a low side, LS, switch (33) and a LS gate driver (34), each of HS switch (31) and LS switch (33) adopting a power MOSFET, wherein

the driver (1) further comprises drain-source voltage monitoring circuits (6), each connected to a respective power MOSFET and the dead time control means (4) respectively,

wherein the drain-source voltage monitoring circuits (6) are configured to monitor a voltage difference between a drain electrode and a source electrode of a power MOSFET on one side in a half bridge, and output a switch off signal to the dead time control means (4) when the voltage difference is bigger than a predetermined voltage being larger than zero,

wherein after receiving the switch off signal from the drain-source voltage monitor circuit (6), the dead time control means (4) is configured to generate a switch on control signal immediately to allow a power MOSFET on other side in the half bridge to switch on;

**characterized in that**

each of the drain-source voltage monitoring circuits (6) comprises

a first resistor (R1) configured to convert a voltage difference between the drain and the source of a respective power MOSFET on one side in a half bridge into current;

a pair of p-channel current mirrors (62), an input thereof being connected to the first resistor (R1), a reference end thereof being connected to the drain of the power MOSFET ,for copying the current from the first resistor (R1) based on a first copying ratio thereof, the first resistor being connected between the input of the pair of p-channel current mirrors and the source of the power MOSFET;

a pair of n-channel current mirrors (63), an input of the pair of n-channel current mirrors (63) being connected to an output of the pair of p-channel current mirrors (62), and a reference end of the pair of n-channel current mirrors (63) being connected to the ground, for copying a first current from the first resistor (R1) into a second current according to the first copying ratio in the pair of p-channel current mirrors (62) and a second copying ratio in the pair of n-channel current mirrors (63);

a second resistor (R2), both ends thereof being connected to an output of the pair of n-channel current mirrors (63) and an external stable voltage source (Vbuf) respectively, for converting the second current back to a voltage signal (Vsense) representing a voltage difference; and

a comparator (61), an input thereof being connected to between the first resistor (R1) and the output of the pair of n-channel current mirrors (63), another input thereof being connected to a reference voltage source, and output thereof being connected to the dead time control means (4), for receiving the voltage signal (Vsense) and a predetermined voltage (Vpre) being larger than zero provided from the reference voltage source, comparing them with each other, and outputting a switch off signal to the dead time control means (4) when the voltage signal (Vsense) is lower than the predetermined voltage (Vpre).

4.  The driver (1) according to claim 3, further comprising a pre-driver (7), wherein the dead time control means (4) is included in the pre-driver (7) instead of the micro-controller (2), and the pre-driver (7) is connected to each of drain-source voltage monitoring circuits (6) and the micro-controller (2) respectively, wherein each of drain-source voltage monitoring circuits (6) monitors a voltage difference between drain and source node of a respective power MOSFET on one side in a half bridge, compares the voltage difference with a predetermined voltage being larger than zero and outputs a switch off signal to the pre-driver (7) when the voltage difference is lower than the predetermined voltage, wherein after receiving the switch off signal from the drain-source voltage monitor circuit (6), the dead time control means (4) generates a switch on control signal immediately to allow a power MOSFET on other side in the half bridge to switch on.

5.  A three-phase brushless direct-current, BLDC, motor including the driver (1) according to any one of claims 1-4.

**Patentansprüche**

1.  Treiber (1) für einen dreiphasigen bürstenlosen Gleichstrommotor bzw. BLDC-Motor,
    wobei ein Ausgang und ein Eingang des Treibers mit einem Stator (8) in dem Motor bzw. einem Mikrocontroller (2) verbunden werden können und der Treiber (1) zum Ansteuern des Motors gemäß der Anweisung von dem Mikrocontroller (2) eingerichtet ist, wobei der Treiber (1) eine dreiphasige Leistungsstufe bestehend aus drei Halbbrücken beinhaltet und der Mikrocontroller (2) ein Totzeitsteuermittel (4) beinhaltet,
    wobei jede der drei Halbbrücken ein Paar aus einem High-Side- bzw. HS-Schalter (31) und einem HS-Gate-Treiber (32) sowie ein Paar aus einem Low-Side- bzw. LS-Schalter (33) und einem LS-Gate-Treiber (34) umfasst, wobei der HS-Schalter (31) und der LS-Schalter (33) jeweils einen Leistungs-MOSFET nutzen, wobei der Treiber (1) ferner Gate-Source-Spannungsüberwachungsschaltungen (5) umfasst, die jeweils mit einem jeweiligen Leistungs-MOSFET und dem Totzeitsteuermittel (4) verbunden sind, wobei die Gate-Source-Spannungsüberwachungsschaltungen (5) ausgelegt sind zum Überwachen einer Spannungsdifferenz zwischen einer Gate-Elektrode und einer Source-Elektrode eines Leistungs-MOSFET auf einer Seite in einer Halbbrücke, Vergleichen der Spannungsdifferenz mit einer Einschaltschwelle des Leistungs-MOSFET und Ausgeben eines Ausschaltsignals an das Totzeitsteuermittel (4), wenn die Spannungsdifferenz geringer als die Einschaltschwelle des Leistungs-MOSFET ist,
    wobei das Totzeitsteuermittel (4) nach dem Empfangen des Ausschaltsignals von der Gate-Source-Spannungsüberwachungsschaltung (5) ausgelegt ist zum sofortigen Erzeugen eines Einschaltsteuersignals, um ein Einschalten eines Leistungs-MOSFET auf der anderen Seite in der Halbbrücke zu gestatten;
    **dadurch gekennzeichnet, dass**
    die Gate-Source-Spannungsüberwachungsschaltungen (5) jeweils Folgendes umfassen:

    einen ersten Widerstand (R1), der zum Umwandeln einer Spannungsdifferenz zwischen dem Gate und der Source eines jeweiligen Leistungs-MOSFET auf einer Seite in einer Halbbrücke in Strom ausgelegt ist;
    ein Paar aus p-Kanal-Stromspiegeln (52), wobei ein Eingang davon mit dem ersten Widerstand (R1) verbunden ist, wobei ein Referenzende davon mit dem Gate des Leistungs-MOSFET verbunden ist, zum Kopieren des Stroms von dem ersten Widerstand (R1) basierend auf einem ersten Kopierverhältnis, wobei der erste Widerstand zwischen den Eingang des Paares von p-Kanal-Stromspiegeln und die Source des Leistungs-MOSFET geschaltet ist;
    ein Paar aus n-Kanal-Stromspiegeln (53), wobei ein Eingang des Paares aus n-Kanal-Stromspiegeln (53) mit einem Ausgang des Paares aus p-Kanal-Stromspiegeln (52) verbunden ist, und wobei ein Ausgang des Paares aus n-Kanal-Stromspiegeln (53) mit Masse (GND) verbunden ist,
    zum Kopieren eines ersten Stroms von dem ersten Widerstand (R1) in einen zweiten Strom gemäß dem ersten Kopierverhältnis in dem ersten Paar aus p-Kanal-Stromspiegeln (52) und einem zweiten Kopierverhältnis in dem Paar aus n-Kanal-Stromspiegeln (53);
    einen zweiten Widerstand (R2), der mit einem Ausgang des Paares aus n-Kanal-Stromspiegeln (53) bzw. einer externen stabilen Spannungsquelle (Vbuf) verbunden ist, zum Umwandeln des zweiten Stroms zurück in ein Spannungssignal (Vsense), das die Spannungsdifferenz repräsentiert; und

einen Komparator (51), wobei ein Eingang davon zwischen den ersten Widerstand (R1) und das Paar aus n-Kanal-Stromspiegeln (53) geschaltet ist, wobei ein anderer Eingang davon mit einer Referenzspannungsquelle (Vref) verbunden ist und ein Ausgang davon mit dem Totzeitsteuermittel (4) verbunden ist, zum Empfangen des Spannungssignals (Vsense) und einer Referenzspannung (Vref), die gleich der von der Referenzspannungsquelle bereitgestellten Einschaltschwelle ist, Vergleichen dieser miteinander und Ausgeben eines Ausschaltsignals an das Totzeitsteuermittel (4), wenn das Spannungssignal (Vsense) geringer als die Referenzspannung (Vref) ist.

2. Treiber (1) nach Anspruch 1, ferner umfassend einen Vortreiber, wobei das Totzeitsteuermittel in dem Vortreiber (7) anstatt dem Mikrocontroller (2) enthalten ist und der Vortreiber (7) mit jeder der Gate-Source-Spannungsüberwachungsschaltungen (5) bzw. dem Mikrocontroller (2) verbunden ist, wobei jede der Gate-Source-Spannungsüberwachungsschaltungen (5) eine Spannungsdifferenz zwischen einem Gate- und einem Source-Knoten eines jeweiligen Leistungs-MOSFET auf einer Seite in einer Halbbrücke überwacht, die Spannungsdifferenz mit einer Einschaltschwelle des jeweiligen Leistungs-MOSFET vergleicht und ein Ausschaltsignal an das Totzeitsteuermittel (4) ausgibt, wenn die Spannungsdifferenz geringer als die Einschaltschwelle ist, wobei das Totzeitsteuermittel (4) nach dem Empfangen des Ausschaltsignals von der Gate-Source-Spannungsüberwachungsschaltung (5) sofort ein Einschaltsteuersignal erzeugt, um ein Einschalten eines Leistungs-MOSFET auf einer anderen Seite in der Halbbrücke zu gestatten.

3. Treiber (1) für einen dreiphasigen bürstenlosen Gleichstrommotor bzw. BLDC-Motor, wobei ein Ausgang und ein Eingang des Treibers (1) mit einem Stator in dem Motor bzw. einem Mikrocontroller (2) verbunden werden können und der Treiber (1) zum Ansteuern des Motors gemäß der Anweisung von dem Mikrocontroller (2) eingerichtet ist, wobei der Treiber (1) eine dreiphasige Leistungsstufe bestehend aus drei Halbbrücken beinhaltet und der Mikrocontroller (2) ein Totzeitsteuermittel (4) beinhaltet, wobei jede der drei Halbbrücken ein Paar aus einem High-Side- bzw. HS-Schalter (31) und einem HS-Gate-Treiber (32) sowie ein Paar aus einem Low-Side- bzw. LS-Schalter (33) und einem LS-Gate-Treiber (34) umfasst, wobei der HS-Schalter (31) und der LS-Schalter (33) jeweils einen Leistungs-MOSFET nutzen, wobei der Treiber (1) ferner Drain-Source-Spannungsüberwachungsschaltungen (6) umfasst, die jeweils mit einem jeweiligen Leistungs-MOSFET bzw. dem Totzeitsteuermittel (4) verbunden sind, wobei die Drain-Source-Spannungsüberwachungsschaltungen (6) ausgelegt sind zum Überwachen einer Spannungsdifferenz zwischen einer Drain-Elektrode und einer Source-Elektrode eines Leistungs-MOSFET auf einer Seite in einer Halbbrücke und Ausgeben eines Ausschaltsignals an das Totzeitsteuermittel (4), wenn die Spannungsdifferenz größer als eine vorbestimmte Spannung, die mehr als 0 beträgt, ist, wobei das Totzeitsteuermittel (4) nach dem Empfangen des Ausschaltsignals von der Drain-Source-Spannungsüberwachungsschaltung (6) ausgelegt ist zum sofortigen Erzeugen eines Einschaltsteuersignals, um ein Einschalten eines Leistungs-MOSFET auf der anderen Seite in der Halbbrücke zu gestatten;

**dadurch gekennzeichnet, dass**

die Drain-Source-Spannungsüberwachungsschaltungen (6) jeweils Folgendes umfassen:

einen ersten Widerstand (R1), der zum Umwandeln einer Spannungsdifferenz zwischen dem Drain und der Source eines jeweiligen Leistungs-MOSFET auf einer Seite in einer Halbbrücke in Strom ausgelegt ist;

ein Paar aus p-Kanal-Stromspiegeln (62), wobei ein Eingang davon mit dem ersten Widerstand (R1) verbunden ist, wobei ein Referenzende davon mit dem Drain des Leistungs-MOSFET verbunden ist, zum Kopieren des Stroms von dem ersten Widerstand (R1) basierend auf einem ersten Kopierverhältnis davon, wobei der erste Widerstand zwischen den Eingang des Paares von p-Kanal-Stromspiegeln und die Source des Leistungs-MOSFET geschaltet ist;

ein Paar aus n-Kanal-Stromspiegeln (63), wobei ein Eingang des Paares aus n-Kanal-Stromspiegeln (63) mit einem Ausgang des Paares aus p-Kanal-Stromspiegeln (62) verbunden ist, und wobei ein Referenzende des Paares aus n-Kanal-Stromspiegeln (63) mit Masse verbunden ist, zum Kopieren eines ersten Stroms von dem ersten Widerstand (R1) in einen zweiten Strom gemäß dem ersten Kopierverhältnis in dem Paar aus p-Kanal-Stromspiegeln (62) und einem zweiten Kopierverhältnis in dem Paar aus n-Kanal-Stromspiegeln (63);

einen zweiten Widerstand (R2), wobei beide Enden davon mit einem Ausgang des Paares aus n-Kanal-Stromspiegeln (63) bzw. einer externen stabilen Spannungsquelle (Vbuf) verbunden ist, zum Umwandeln des zweiten Stroms zurück in ein Spannungssignal (Vsense), das eine Spannungsdifferenz repräsentiert; und

einen Komparator (61), wobei ein Eingang davon zwischen den ersten Widerstand (R1) und den Ausgang des Paares aus n-Kanal-Stromspiegeln (63) geschaltet ist, wobei ein anderer Eingang davon mit einer Referenzspannungsquelle verbunden ist und ein Ausgang davon mit dem Totzeitsteuermittel (4) verbunden ist, zum Empfangen des Spannungssignals (Vsense) und einer vorbestimmten Spannung (Vpre), die größer als null ist, bereitgestellt von der Referenzspannungsquelle, Vergleichen dieser miteinander und Ausgeben eines Ausschaltsignals an das Totzeitsteuermittel (4), wenn das Spannungssignal (Vsense) geringer als die vorbestimmte Spannung (Vpre) ist.

4. Treiber (1) nach Anspruch 3, ferner umfassend einen Vortreiber (7), wobei das Totzeitsteuermittel (4) in dem Vortreiber (7) anstatt dem Mikrocontroller (2) enthalten ist und der Vortreiber (7) mit jeder der Drain-Source-Spannungsüberwachungsschaltungen (6) bzw. dem Mikrocontroller (2) verbunden ist, wobei jede der Drain-Source-Spannungsüberwachungsschaltungen (6) eine Spannungsdifferenz zwischen einem Drain- und einem Source-Knoten eines jeweiligen Leistungs-MOSFET auf einer Seite in einer Halbbrücke überwacht, die Spannungsdifferenz mit einer vorbestimmten Spannung, die größer als null ist, vergleicht und ein Ausschaltsignal an den Vortreiber (7) ausgibt, wenn die Spannungsdifferenz geringer als die vorbestimmte Spannung ist, wobei das Totzeitsteuermittel (4) nach dem Empfangen des Ausschaltsignals von der Drain-Source-Spannungsüberwachungsschaltung (6) sofort ein Einschaltsteuersignal erzeugt, um ein Einschalten eines Leistungs-MOSFET auf einer anderen Seite in der Halbbrücke zu gestatten.

5. Dreiphasiger bürstenloser Gleichstrommotor bzw. BLDC-Motor, der den Treiber (1) nach einem der Ansprüche 1-4 beinhaltet.

## Revendications

1. Circuit d'attaque (1) pour moteur triphasé à courant continu sans balai, BLDC,
   dans lequel la sortie et l'entrée du circuit d'attaque peuvent être respectivement connectées à un stator (8) dans le moteur et à un microcontrôleur (2), et
   le circuit d'attaque (1) est adapté pour commander le moteur selon l'instruction du microcontrôleur (2),
   où le circuit d'attaque (1) comprend un étage de puissance triphasé constitué de trois demi-ponts, et le microcontrôleur (2) comprend un moyen de contrôle de temps mort (4),
   où chacun des trois demi-ponts comprend une paire d'un commutateur côté haut, HS, (31) et d'un circuit d'attaque de grille HS (32) et une paire d'un commutateur côté bas, LS, (33) et d'un circuit d'attaque de grille LS (34), chacun des commutateurs HS (31) et LS (33) adoptant un MOSFET de puissance, où :

   le circuit d'attaque (1) comprend en outre des circuits de surveillance de tension grille-source (5), chacun étant connecté à un MOSFET de puissance respectif et au moyen de contrôle de temps mort (4), les circuits de surveillance de tension grille-source (5) sont configurés pour surveiller une différence de tension entre une électrode de grille et une électrode de source d'un MOSFET de puissance sur un côté dans un demi-pont, comparer la différence de tension avec un seuil de mise en marche du MOSFET de puissance, et délivrer un signal de mise à l'arrêt au moyen de contrôle de temps mort (4) lorsque la différence de tension est inférieure au seuil de mise en marche du MOSFET de puissance,
   où, après réception du signal de mise à l'arrêt provenant du circuit de surveillance de tension grille-source (5), le moyen de contrôle de temps mort (4) est configuré pour générer un signal de commande de mise en marche immédiatement pour permettre à un MOSFET de puissance de l'autre côté dans le demi-pont de se mettre en marche ;
   **caractérisé en ce que** :
   chacun des circuits de surveillance de tension grille-source (5) comprend :

   une première résistance (R1) configurée pour convertir en courant une différence de tension entre la grille et la source d'un MOSFET de puissance respectif sur un côté dans un demi-pont ;
   une paire de miroirs de courant à canal p (52), dont une entrée est connectée à la première résistance (R1), dont une extrémité de référence est connectée à la grille du MOSFET de puissance, pour copier le courant provenant de la première résistance (R1) sur la base d'un premier rapport de copie, la première résistance étant connectée entre l'entrée de la paire de miroirs de courant à canal p et la source du MOSFET de puissance ;
   une paire de miroirs de courant à canal n (53), une entrée de la paire de miroirs de courant à canal n (53) étant connectée à une sortie de la paire de miroirs de courant à canal p (52), et une sortie de la paire de miroirs de courant à canal n (53) étant connectée à la masse (GND), pour copier un premier courant provenant de la première résistance (R1) en un second courant selon le premier rapport de copie de la première paire de miroirs de courant à canal p (52) et un second rapport de copie de la paire de miroirs de courant à canal n (53) ;

une seconde résistance (R2), connectée à une sortie de la paire de miroirs de courant à canal n (53) et à une source de tension stable externe (Vbuf), respectivement, pour reconvertir le second courant en un signal de tension (Vsense) représentant la différence de tension ; et

un comparateur (51), dont une entrée est connectée entre la première résistance (R1) et la paire de miroirs de courant à canal N (53), dont une autre entrée est connectée à une source de tension de référence (Vref), et dont la sortie est connectée au moyen de contrôle de temps mort (4), pour recevoir le signal de tension (Vsense) et une tension de référence (Vref) qui est égale au seuil de mise en marche fourni par la source de tension de référence, les comparer l'un à l'autre, et délivrer un signal de mise à l'arrêt au moyen de contrôle de temps mort (4) lorsque le signal de tension (Vsense) est inférieur à la tension de référence (Vref).

2. Circuit d'attaque (1) selon la revendication 1, comprenant en outre un pré-circuit d'attaque, où le moyen de contrôle de temps mort est inclus dans le pré-circuit d'attaque (7) au lieu du microcontrôleur (2), et le pré-circuit d'attaque (7) est connecté à chacun des circuits de surveillance de tension grille-source (5) et au microcontrôleur (2), respectivement, où chacun des circuits de surveillance de tension grille-source (5) surveille une différence de tension entre la grille et le nœud de source d'un MOSFET de puissance respectif sur un côté dans un demi-pont, compare la différence de tension avec un seuil de mise en marche du MOSFET de puissance respectif et délivre en sortie un signal de mise à l'arrêt vers le moyen de contrôle de temps mort (4) lorsque la différence de tension est inférieure au seuil de mise en marche, où, après réception du signal de mise à l'arrêt provenant du circuit de surveillance de tension grille-source (5), le moyen de contrôle de temps mort (4) génère un signal de commande de mise en marche immédiatement pour permettre à un MOSFET de puissance de l'autre côté dans le demi-pont de se mettre en marche.

3. Circuit d'attaque (1) pour moteur triphasé à courant continu sans balai, BLDC,
dans lequel la sortie et l'entrée du circuit d'attaque (1) peuvent être respectivement connectées à un stator dans le moteur et à un microcontrôleur (2), et
le circuit d'attaque (1) est adapté pour commander le moteur selon l'instruction provenant du microcontrôleur (2),
où le circuit d'attaque (1) comprend un étage de puissance triphasé constitué de trois demi-ponts, et le microcontrôleur (2) comprend un moyen de contrôle de temps mort (4),
où chacun des trois demi-ponts comprend une paire d'un commutateur côté haut, HS, (31) et d'un circuit d'attaque de grille HS (32) et une paire d'un commutateur côté bas, LS, (33) et d'un circuit d'attaque de grille LS (34), chacun des commutateurs HS (31) et LS (33) adoptant un MOSFET de puissance, où :

le circuit d'attaque (1) comprend en outre des circuits de surveillance de tension drain-source (6), chacun étant connecté à un MOSFET de puissance respectif et au moyen de contrôle de temps mort (4), respectivement, où les circuits de surveillance de tension drain-source (6) sont configurés pour surveiller une différence de tension entre une électrode de drain et une électrode de source d'un MOSFET de puissance sur un côté dans un demi-pont, et délivrer un signal de mise à l'arrêt au moyen de contrôle de temps mort (4) lorsque la différence de tension est supérieure à une tension prédéterminée supérieure à zéro, où, après avoir reçu le signal de mise à l'arrêt du circuit de surveillance de tension drain-source (6), le moyen de contrôle de temps mort (4) est configuré pour générer un signal de commande de mise en marche immédiatement pour permettre à un MOSFET de puissance de l'autre côté dans le demi-pont de se mettre en marche ;
**caractérisé en ce que** :
chacun des circuits de surveillance de tension drain-source (6) comprend :

une première résistance (R1) configurée pour convertir en courant une différence de tension entre le drain et la source d'un MOSFET de puissance respectif sur un côté dans un demi-pont ;
une paire de miroirs de courant à canal p (62), dont une entrée est connectée à la première résistance (R1), dont une extrémité de référence est connectée au drain du MOSFET de puissance, pour copier le courant provenant de la première résistance (R1) sur la base du premier rapport de copie de celle-ci, la première résistance étant connectée entre l'entrée de la paire de miroirs de courant à canal p et la source du MOSFET de puissance ;
une paire de miroirs de courant à canal n (63), une entrée de la paire de miroirs de courant à canal n (63) étant connectée à une sortie de la paire de miroirs de courant à canal p (62), et une extrémité de référence de la paire de miroirs de courant à canal n (63) étant connectée à la masse, pour copier un premier courant provenant de la première résistance (R1) en un second courant selon le premier rapport de copie dans la paire de miroirs de courant à canal p (62) et un second rapport de copie dans la paire de miroirs de courant à canal n (63) ;

une seconde résistance (R2), dont les deux extrémités sont respectivement connectées à une sortie de la paire de miroirs de courant à canal N (63) et à une source de tension stable externe (Vbuf), pour reconvertir le second courant en un signal de tension (Vsense) représentant une différence de tension ; et

un comparateur (61), dont une entrée est connectée entre la première résistance (R1) et la sortie de la paire de miroirs de courant à canal N (63), dont une autre entrée est connectée à une source de tension de référence, et dont la sortie est connectée au moyen de contrôle de temps mort (4), pour recevoir le signal de tension (Vsense) et une tension prédéterminée (Vpre) supérieure à zéro fournie par la source de tension de référence, les comparer l'un à l'autre, et délivrer un signal de mise à l'arrêt au moyen de contrôle de temps mort (4) lorsque le signal de tension (Vsense) est inférieur à la tension prédéterminée (Vpre).

4. Circuit d'attaque (1) selon la revendication 3, comprenant en outre un pré-circuit d'attaque (7), dans lequel le moyen de contrôle de temps mort (4) est inclus dans le pré-circuit d'attaque (7) au lieu du microcontrôleur (2), et le pré-circuit d'attaque (7) est connecté à chacun des circuits de surveillance de tension drain-source (6) et au microcontrôleur (2), respectivement, où chacun des circuits de surveillance de tension drain-source (6) surveille une différence de tension entre le nœud de drain et le nœud de source d'un MOSFET de puissance respectif sur un côté dans un demi-pont, compare la différence de tension à une tension prédéterminée supérieure à zéro et délivre en sortie un signal de mise à l'arrêt vers le pré-circuit d'attaque (7) lorsque la différence de tension est inférieure à la tension prédéterminée, où, après avoir reçu le signal de mise à l'arrêt du circuit de surveillance de tension drain-source (6), le moyen de contrôle de temps mort (4) génère un signal de commande de mise en marche immédiatement pour permettre à un MOSFET de puissance de l'autre côté du demi-pont de se mettre en marche.

5. Moteur triphasé à courant continu sans balai, BLDC, comprenant le circuit d'attaque (1) selon l'une quelconque des revendications 1 à 4.

**Figure 1**

51

4

VCC

Vgate

Vsource

Vref

+

−

GND

**Figure 2**

**Figure 3**

**Figure 4**

Figure 5

**Figure 6**

**Figure 7**

**Figure 8**

**Figure 9**

**Figure 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5408150 A
- US 4953070 A
- DE 10343278
- US 5187387 A
- JP S63265174 A